# EUROPEAN PATENT APPLICATION

(11) **EP 3 800 670 A2**
(43) Date of publication of application: **07.04.2021**
(21) Application number: 20214235.2
(22) Date of filing: 15.12.2020
(51) Int. Cl.: H01L 29/78, H01L 21/336, H01L 29/40

(54) **SEMICONDUCTOR DEVICE AND METHOD OF FORMING THE SAME**

(30) Priority: 07.08.2020 CN 202010786200
(71) Applicant: Semiconductor Manufacturing Electronics (Shaoxing) Corporation, 312000 Shaoxing Zhejiang (CN)
(72) Inventor: SONG, Jinxing, Shaoxing, Zhejiang 312000 (CN); CONG, Maojie, Shaoxing, Zhejiang 312000 (CN); YUAN, Jiagui, Shaoxing, Zhejiang 312000 (CN)
(74) Representative: Banzer, Hans-Jörg

(57) **Abstract**

A semiconductor device and a method of forming the device are disclosed. In the semiconductor device, a shielded gate trench field effect transistor (FET) is formed in a cell region, and a super barrier rectifier (SBR) is formed in a non-cell region. In the SBR, a second dielectric layer has an upper dielectric layer and a lower dielectric layer, which are joined to each other smoothly by virtue of a beak-like portion. This avoids the presence of any sharp corner between the upper and lower dielectric layers and effectively mitigates the problem of an excessively small thickness of the upper dielectric layer at a bottom portion thereof, which tends to cause current leakage.

## Description

### TECHNICAL FIELD

The present invention relates to the field of semiconductor technology and, in particular, to a semiconductor device and a method of forming the semiconductor device.

### BACKGROUND

A shielded gate trench (SGT) field effect transistor (FET) features low gate-drain capacitance Cgd, very low on-resistance and high voltage resistance, which are helpful in improving the flexible application of a semiconductor integrated circuit incorporating the FET. Specifically, a shielded gate trench FET has significantly reduced gate-drain capacitance attributable to a shield electrode positioned under a gate electrode, as well as reduced on-resistance resulting from a high concentration of dopant carriers in a drift region, which can provide additional benefits to the device's breakdown voltage.

In addition, for a semiconductor device employing a shielded gate trench FET, in order to achieve rapid turn-off and increase the reverse recovery speed when turning off the transistor, an additional rectifier such as an SBR (Super Barrier Rectifier) is incorporated for speeding up the device's turn-off during the turn-off process of the transistor.

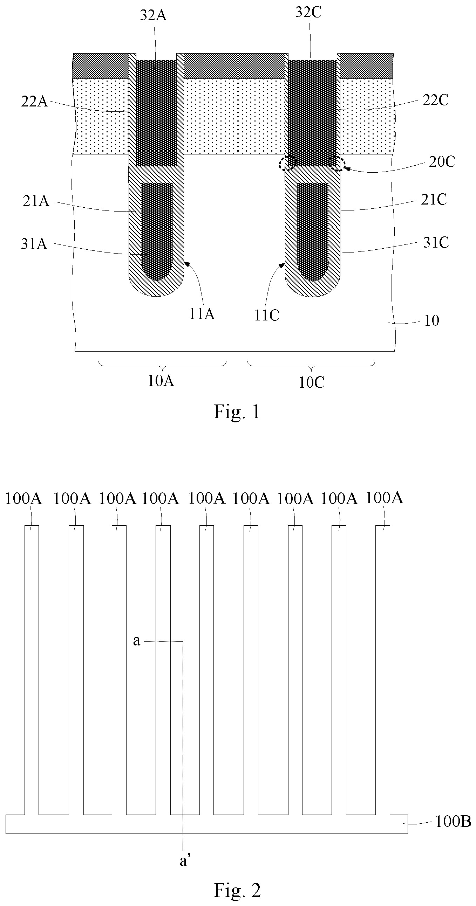

Reference can be made specifically to the schematic of Fig. 1, which illustrates a semiconductor device designed with both a cell region 10A, where a shielded gate trench FET is formed, and a rectifier region 10C where an SBR is formed. At present, the formation of the shielded gate trench FET and of the SBR typically includes the following steps.

In a first step, a substrate 10 is directly etched with the aid of a mask layer so that trenches 11A/11C each with a desired depth are respectively formed in the cell region 10A and the rectifier region 10C.

In a second step, an initial dielectric layer 21A/21C is formed, which covers bottoms and sidewalls of both the trenches 11A/11C.

In a third step, an electrode material layer is deposited and an etch-back process is performed thereon to lower a top surface of the electrode material within the individual trenches, resulting in the formation of shield electrodes 31A/31C at respective bottoms of the trenches. As a result, portions of the initial dielectric layer 21A/21C above the shield electrodes are exposed.

In a fourth step, the portions of the initial dielectric layer 21A/21C above the shield electrodes are removed, exposing the underlying sidewall portions of the trenches 11A/11C higher than the shield electrodes. It will be recognized that the etch-back process performed on the electrode material in the third step may bring damage to the exposed initial dielectric layer and such damaged portions of the initial dielectric layer can be removed in this step.

In a fifth step, a photolithography process using a first mask is carried out such that the rectifier region 10C is shielded, with the cell region 10A being still exposed. A first oxidation process is then performed on the exposed upper sidewall portions of the trench 11A in the cell region 10A, resulting in the formation of an upper dielectric layer 22A with a first thickness.

In a sixth step, another photolithography process using a second mask is performed such that the cell region 10A is shielded and the rectifier region 10C is exposed. A second oxidation process is then performed on the exposed upper sidewall portions of the trench 11C in the rectifier region 10C, resulting in the formation of an upper dielectric layer 22C with a second thickness that is smaller than the first thickness.

In a seventh step, gate electrodes 32A/32C are formed by filling the trenches 11A/11C in the cell region 10A and the rectifier region 10C with a suitable material.

It is to be noted that the thinner upper dielectric layer 22C formed in the rectifier region 10C allows the resulting SBR to be turned on at a voltage that is not high enough to turn on the device. However, it is just the demanding requirement of a small thickness of the upper dielectric layer 22C in the rectifier region 10C that tends to become a cause of insufficient oxidation at the corners 20C (where there may be, for example, insufficient contact between oxygen and the sidewalls) during the oxidation process, which may lead to an oxide layer thickness at the corners 20C that is too small to prevent current leakage.

Additionally, since the upper dielectric layers 22A and 22C that respectively determine the performance of the shielded gate trench FET in the cell region 10A and that of the SBR in the rectifier region 10C are generally required to have different thicknesses, they have to be formed in separate steps employing different photolithography processes using distinct photomasks, making the fabrication complicated and costly. Further, in each of the photolithography processes, one of the trenches is filled and shield with photoresist, the use of which tends to be associated with the problem of photoresist residual in the trench.

### SUMMARY OF THE INVENTION

It is an objective of the present invention to provide a semiconductor device which is free of current leakage and can be fabricated using a simpler process.

To this end, the provided semiconductor device includes:
a substrate defining a cell region and a non-cell region, the non-cell region including a source-connecting region;
a shielded gate trench FET formed in the cell region, the shielded gate trench FET including: a first trench formed in the substrate; a first dielectric layer covering both a bottom and a sidewall of the first trench; and a shield electrode, a separation layer and a first gate electrode, which are sequentially stacked in the first trench; and
an SBR formed in the non-cell region, the SBR including: a second trench formed in the substrate; a second dielectric layer covering both a bottom and a sidewall of the second trench, the second dielectric layer including a second lower dielectric layer and a second upper dielectric layer residing on and joined to the second lower dielectric layer, the second upper dielectric layer having a thickness smaller than a thickness of the second lower dielectric layer, the second lower dielectric layer having a beak-like portion proximal to and tapered in thickness toward the second upper dielectric layer, the second upper dielectric layer smoothly joined to the beak-like portion of the second lower dielectric layer, the thickness of the second upper dielectric layer further being smaller than a portion of the first dielectric layer that vertically corresponds to the first gate electrode; and a second gate electrode filling up a bottom portion of the second trench, with a top surface of the second gate electrode being above the shield electrode, both the second gate electrode and the shield electrode being electrically picked up by the source-connecting region.

Optionally, the non-cell region may include a rectifier region, in addition to the source-connecting region, wherein the SBR is formed in the rectifier region, and wherein a source-connecting structure is formed in the source-connecting region, the source-connecting structure including: a third trench formed in the substrate; a third dielectric layer covering both a bottom and a sidewall of the third trench; and a connecting electrode filling up the third trench, the connecting electrode connecting to the shield electrode for electrically picking up the shield electrode.

Optionally, in the semiconductor device, the substrate may define a plurality of cell regions and at least one rectifier region, wherein the first trenches of the plurality of cell regions all extend in a predetermined direction, the second trench in each of the at least one rectifier region interposed between adjacent first trenches, and wherein the first trenches all extend to the third trench at ends thereof to communicate with the third trench.

Optionally, a source-connecting structure may be formed in the source-connecting region, the source-connecting structure including:
a third trench formed in the substrate, wherein at least part of the third trench constitutes the second trench of the SBR and is defined as a function-integrated region;
a third dielectric layer covering both a bottom and a sidewall of the third trench, wherein a portion of the third dielectric layer formed within the function-integrated region constitutes the second dielectric layer of the SBR; and
a connecting electrode filling up the third trench, the connecting electrode electrically connecting the shield electrode, wherein a portion of the connecting electrode formed within the function-integrated region forms the second gate electrode of the SBR.

Optionally, in the semiconductor device, the substrate may define a plurality of cell regions, wherein the first trenches of the plurality of cell regions all extend in a predetermined direction, and wherein the first trenches all extend to the second trench at ends thereof to communicate with the second trench.

Optionally, the thickness of the second upper dielectric layer may be between 40 Å and 100 Å.

Optionally, the first dielectric layer may include a first lower dielectric layer and a first upper dielectric layer residing on and joined to the first lower dielectric layer, the first lower dielectric layer covering both the bottom of the first trench and a portion of the sidewall of the first trench that corresponds to the shield electrode, the first upper dielectric layer covering at least a portion of the sidewall of the first trench that corresponds to the first gate electrode.

Optionally, the first lower dielectric layer may have a beak-like portion proximal to and tapered in thickness toward the first upper dielectric layer, wherein the beak-like portion of the first lower dielectric layer is located at a height that is equal to a height where the beak-like portion of the second lower dielectric layer is located.

Optionally, the first trench and the second trench are equal in depth.

Optionally, the semiconductor device may include a source region and a well region formed in the substrate beside the first trench and each having a lateral overlap with the first gate electrode, the source region and the well region further extending to the substrate beside the second trench and each having a lateral overlap with the second gate electrode.

The present invention also provides a method of forming a semiconductor device, including:
providing a substrate defining a cell region and a non-cell region;
forming a plurality of trenches in the substrate, the plurality of trenches including a first trench in the cell region and a second trench in the non-cell region;
forming a lower dielectric layer covering both a bottom and a lower portion of a sidewall of each of the plurality of trenches, wherein forming the lower dielectric layer comprises forming a first lower dielectric layer in the first trench and a second lower dielectric layer in the second trench so that at least an end portion of the second lower dielectric layer is a beak-like portion with a gradually reduced thickness;
forming an upper dielectric layer covering an upper portion of the sidewall of each of the plurality of trenches, wherein forming the upper dielectric layer comprises forming a sacrificial dielectric layer on the upper portion of the sidewall of the first trench and a second upper dielectric layer on the upper portion of the sidewall of the second trench, the second upper dielectric layer having a thickness smaller than a thickness of the second lower dielectric layer, the second upper dielectric layer smoothly joined to the beak-like portion of the second lower dielectric layer; and
forming electrodes in the plurality of trenches, wherein forming the electrodes comprises: forming a shield electrode in a bottom portion of the first trench and a second gate electrode in the second trench, the second gate electrode filling up a bottom portion of the second trench and having a top surface above the shield electrode; and successively forming, above the shield electrode, a separation layer, a first upper dielectric layer and a first gate electrode in the first trench, the first upper dielectric layer having a thickness greater than a thickness of the second upper dielectric layer.

Optionally, forming the plurality of trenches in the substrate may include:
forming a mask layer on a top surface of the substrate and etching the substrate using the mask layer, so that a first upper trench is formed in the substrate in the cell region and a second upper trench is formed in the substrate in the non-cell region;
successively forming a silicon oxide layer and a silicon nitride layer over a sidewall of each of the first and second upper trenches, with a bottom of each of the first and second upper trenches being exposed; and
etching the bottoms of the first and second upper trenches with the silicon nitride layers serving as masks so that the bottoms of the first and second upper trenches extend downward to form the first and the second trenches.

Optionally, forming the lower dielectric layer covering both the bottom and the lower portion of the sidewall of each of the plurality of trenches may include: performing a local oxidation process with the silicon oxide layer and the silicon nitride layer together serving as a mask, thereby forming the first lower dielectric layer having a beak-like portion in the first trench and the second lower dielectric layer having a beak-like portion in the second trench.

Optionally, forming the upper dielectric layer covering the upper portion of the sidewall of each of the plurality of trenches may include:
removing the silicon oxide layer and the silicon nitride layer, exposing the upper portion of the sidewall of each of the first and second trenches above the lower dielectric layer; and performing a first oxidation process, thereby forming the sacrificial dielectric layer on the upper portion of the sidewall of the first trench and the second upper dielectric layer on the upper portion of the sidewall of the second trench.

Optionally, forming the electrodes in the plurality of trenches may include:
filling each of the plurality of trenches with an electrode material layer, wherein a portion of the electrode material layer in the second trench forms the second gate electrode that covers the second upper dielectric layer;
removing a portion of the electrode material layer in the first trench so that a remaining portion of the electrode material layer on the bottom of the first trench forms the shield electrode and the sacrificial dielectric layer in the first trench is exposed;
forming the separation layer in the first trench to cover the shield electrode and removing the sacrificial dielectric layer, thereby exposing the upper portion of the sidewall of the first trench; and
forming the first upper dielectric layer in the first trench by performing a second oxidation process and forming the first gate electrode in the first trench.

Optionally, the method may further include forming a source region and a well region, the source region and the well region both formed in the substrate beside the first trench and thereby forming a shielded gate trench field effect transistor (FET) in the cell region, the well region and the source region also both formed in the substrate beside the second trench and thereby forming a super barrier rectifier (SBR) in the non-cell region.

In the semiconductor device provided in the present invention, a first dielectric layer, a shield electrode, a first gate electrode, a well region and a source region are formed in each cell region and make up a shielded gate trench FET, and a second dielectric layer, a second gate electrode, a well region and a source region are formed in each non-cell region and make up an SBR. In the SBR, an upper dielectric layer of the second dielectric layer has a thickness smaller than that of an upper dielectric layer of the first dielectric layer in the shielded gate trench FET. In this way, the SBR has a low threshold voltage, which allows it to be turned on, at a voltage that is not high enough to turn on the shielded gate trench FET, to provide current rectification that can speed up the device' turn-off.

In the SBR, a lower dielectric layer of the second dielectric layer has a beak-like portion, which allows the upper dielectric layer of the second dielectric layer to be smoothly joined to the lower dielectric layer, without any sharp corner that may cause electric field concentration present at the portion where the upper and lower dielectric layers of the second dielectric layer are joined to each other. In addition, this can effectively mitigate the problem of an excessively small thickness of the second dielectric layer at said portion, thus significantly lowering the risk of the device's current leakage.

Further, the second gate electrode in the SBR is an integral part filling a bottom portion of the second trench and having a top surface situated above the shield electrode. Compared with the conventional structure split into upper and lower portions, such an integral structure enables easier formation of the second gate electrode and can simplify the formation of the upper dielectric layer of the second dielectric layer. Specifically, the integral second gate electrode can cover the majority of the upper dielectric layer, making it possible to directly retain this upper dielectric layer without the need to employ an additional photolithography process for shielding the first trench with photoresist. Therefore, this can save a photolithography process and avoid the problem of residual photoresist in the first trench, which may degrade the performance of the resulting shielded gate trench FET.

### BRIEF DESCRIPTION OF THE DRAWINGS

Fig. 1 schematically illustrates the structure of a conventional semiconductor device.
Fig. 2 shows the layout of a semiconductor device according to a first embodiment of the present invention.
Fig. 3 is a schematic cross-sectional view of the semiconductor device of Fig. 2 taken along the direction aa'.
Fig. 4 shows the layout of a semiconductor device according to a second embodiment of the present invention.
Fig. 5 is a flowchart of a method of forming the semiconductor device according to the first embodiment of the present invention.
Figs. 6 to 15 schematically illustrate intermediate structures during the method of forming the semiconductor device according to the first embodiment of the present invention.

### List of Reference Numerals in the Drawings

- 10C: Rectifier Region
- 11A/11C: Trench
- 21A/21C: Initial Dielectric Layer
- 22A/22C: Upper Dielectric Layer
- 20C: Corner
- 31A/31C: Shield electrode
- 32A/32C: Gate Electrode
- 10/100: Substrate
- 10A/100A: Cell Region
- 100B: Source-Connecting Region
- 110A: First Trench
- 111A: First Upper Trench
- 110B: Second Trench
- 111B: Second Upper Trench
- 120: Mask Layer
- 130: Silicon Oxide Layer
- 140: Silicon Nitride Layer
- 200A: First Dielectric Layer
- 210A: First Lower Dielectric Layer
- 220A: First Upper Dielectric Layer
- 200B: Second Dielectric Layer
- 210B: Second Lower Dielectric Layer
- 220B: Second Upper Dielectric Layer
- 310A: Shield electrode
- 320A: First Gate Electrode
- 300B: Second Gate Electrode
- 410: Well Region
- 420: Source Region

### DETAILED DESCRIPTION

The semiconductor device and method proposed herein will be described in greater detail by way of specific embodiments with reference to the accompanying drawings. Features and advantages of the invention will be more apparent from the following detailed description. Note that the figures are provided in a very simplified form not necessarily drawn to scale, with the only intention to facilitate convenience and clarity in explaining the embodiments.

### Embodiment 1

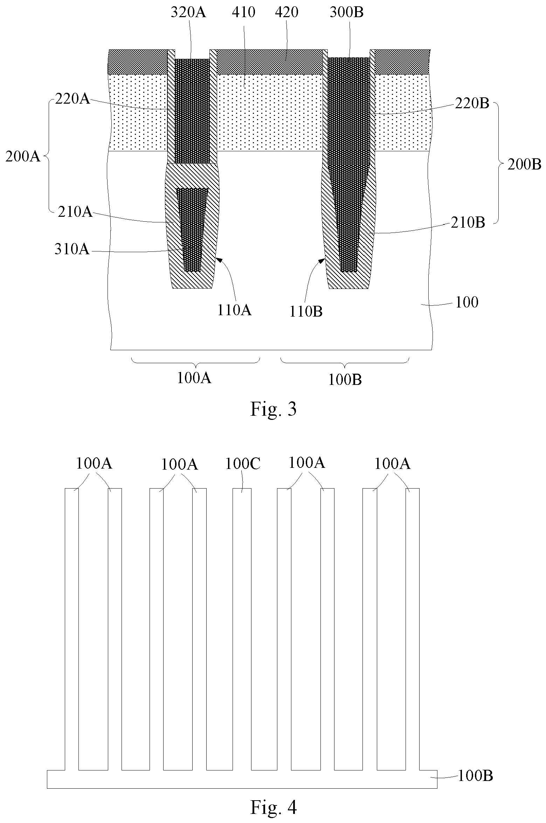

Fig. 2 shows the layout of a semiconductor device according to a first embodiment of the present invention, and Fig. 3 is a schematic cross-sectional view of the semiconductor device of Fig. 2 taken along the direction aa'. As shown in Figs. 2 and 3, the semiconductor device includes a substrate 100 defining cell regions 100A and a non-cell region. Shielded gate trench (SGT) field effect transistors (FETs) are formed in the cell regions 100A. In this embodiment, the semiconductor device contains a plurality of cell regions 100A and hence of shielded gate trench FETs. In addition, a super barrier rectifier (SBR) is formed in the non-cell region.

With continued reference to Figs. 2 and 3, each shielded gate trench FET includes: a first trench 110A formed in the substrate in a corresponding one of the cell regions 100A; a first dielectric layer 200A covering both a bottom and a sidewall of the first trench 110A; and a shield electrode 310A, a separation layer and a first gate electrode 320A, which are stacked one above another in the first trench 110A. In particular, the separation layer is interposed between the shield electrode 310A and the first gate electrode 320A, thus separating the shield electrode 310A from the first gate electrode 320A.

The SBR includes: a second trench 110B formed in the substrate in the non-cell region (i.e., the below-described source-connecting region 100B according to this embodiment); a second dielectric layer 200B covering both a bottom and a sidewall of the second trench 110B; and a second gate electrode 300B filled in the second trench 200B.

In another implementation, the non-cell region may additionally include a source-connecting structure for electrically picking up the shield electrodes in the shielded gate trench FETs.

Specifically, the source-connecting structure may include: a third trench formed in the substrate; a third dielectric layer covering both a bottom and a sidewall of the third trench; and a connecting electrode filled in the third trench, the connecting electrode being connected to, and thus electrically picking up, the shield electrodes in the shielded gate trench FETs.

It is to be noted that the non-cell region may optionally include a rectifier region and a source-connecting region. In this case, the super barrier rectifier (SBR) is formed in the rectifier region and the source-connecting structure in the source-connecting region. In other words, in an optional implementation, the rectifier region and source-connecting region are located in different locations and intended for distinct functions, as will be described in greater detail below.

In another optional implementation, with particular reference to Fig. 2, the non-cell region may include a source-connecting region 100B, which can provide both the functions of electrically picking up the shield electrodes in the shielded gate trench FETs and of accommodating the super barrier rectifier (SBR). That is, in this case, the super barrier rectifier (SBR) is directly integrated in the source-connecting region 100B, dispensing with the need to reserve a separate space for the rectifier region. This can lead to higher space utilization of the cell regions in the device.

In this embodiment, emphasis will be given to the description of the implementation shown in Fig. 2 (i.e., the case with the SBR being integrated in the source-connecting region 100B). In this case, in the source-connecting region 100B, at least part of the third trench can be considered as the second trench of the SBR. For example, the portion of the third trench that constitutes the second trench may be defined as a function-integrated region, with a portion of the third dielectric layer of the source-connecting structure within the function-integrated region providing the second dielectric layer of the SBR, and a portion of the connecting electrode of the source-connecting structure within the function-integrated region providing the second gate electrode of the SBR. Further, a source region and a well region may be formed in the substrate in the function-integrated region.

It will be recognized that the source-connecting region may be defined either in part, or as a whole, the function-integrated region, depending upon what is actually needed by the semiconductor device. Fig. 2 only depicts the essence of how the cell regions and the function-integrated region in the source-connecting region are structured.

With particular reference to Figs. 2 and 3, in this embodiment, the first trenches 110A communicate with the second trench 110B such that the shield electrodes 310A filled in the first trenches 110A are connected to, and thus electrically picked up by, the second gate electrode 300B filled in the second trench 110B. Additionally, the first and second trenches 110A, 110B can be formed in a single step and may thus have equal or almost equal depths.

Further, each first trench 110A extends in a first direction and comes into communication, at one end, with the second trench 110B, and the second trench 110B extends in a second direction. In this embodiment, the first trenches 110A are formed in the respective cell regions 100A, extend in parallel to one another, and all terminate at one end at the second trench 110B.

With particular reference to Fig. 3, the first dielectric layer 200A includes a first lower dielectric layer 210A and a first upper dielectric layer 220A, which are joined to each other in the vertical direction. For example, the first lower dielectric layer 210A may be made up of a portion of the first dielectric layer 200A below a predetermined depth, and the first upper dielectric layer 220A may be made up of the rest of the first dielectric layer 200A above the predetermined depth.

The first lower dielectric layer 210A may cover the bottom of the first trench 110A, as well as a sidewall portion thereof corresponding to the shield electrode 310A. It is to be noted that the first lower dielectric layer 210A may have a thickness, which is determined depending on intended voltage resistance of the resulting shielded gate trench FET and not limited to any particular value. For example, when the shielded gate trench FET is intended for use as a high-voltage transistor, the thickness of the first lower dielectric layer 210A may be relatively large to allow the transistor to have high voltage resistance. On the contrary, when the shielded gate trench FET is to be used as a low-voltage transistor, the first lower dielectric layer 210A may be relatively thin.

The first upper dielectric layer 220A may cover a sidewall portion of the first trench 110A above the first lower dielectric layer 210A, which include portions of the first trench 110A that correspond to the first gate electrode 320A. The first upper dielectric layer 220A is intended to be used as a gate oxide layer of the shielded gate trench FET and may therefore have a thickness determined depending on a desired turn-on voltage of the shielded gate trench FET. In general, in order to ensure sufficient turn-on performance of the shielded gate trench FET, the thickness of the first upper dielectric layer 220A should not be too small.

Moreover, in this embodiment, the thickness of the first upper dielectric layer 220A is smaller than that of the first lower dielectric layer 210A.

As described above, the first gate electrode 320A is disposed above the shield electrode 310A, with the separation layer interposed between the first gate electrode 320A and the shield electrode 310A and separating the first gate electrode 320A and the shield electrode 310A from each other.

In this embodiment, the predetermined depth can be considered to correspond to a bottom of the first gate electrode 320A. On this basis, the first lower dielectric layer 210A includes the portion of the first dielectric layer 200A below the first gate electrode, and the first upper dielectric layer 220A include the rest of the first dielectric layer 200A that vertically corresponds to the first gate electrode 320A.

With continued reference to Fig. 3, in this embodiment, the second dielectric layer 200B includes a second lower dielectric layer 210B and a second upper dielectric layer 220B, which are joined to each other vertically. For example, a portion of the second dielectric layer 200B below the predetermined depth may make up the second lower dielectric layer 210B, and the rest of the second dielectric layer 200B above the predetermined depth may make up the second upper dielectric layer 220B.

As described above, the predetermined depth can be considered to correspond to the bottom of the first gate electrode 320A. On this basis, the second lower dielectric layer 210B includes the portion of the second dielectric layer 200B below the first gate electrode 320A, and the second upper dielectric layer 220B include the rest of the second dielectric layer 200B that vertically corresponds to the first gate electrode 320A.

The second lower dielectric layer 210B covers the bottom of the second trench 110B, as well as a sidewall portion of the second trench 110B below the predetermined depth, the second upper dielectric layer 220B is disposed above, and joined to, the second lower dielectric layer 210B so that it covers a sidewall portion of the second trench 110B above the predetermined depth.

In addition, the second lower dielectric layer 210B is joined smoothly to the second upper dielectric layer 220B. Specifically, an end portion of the second lower dielectric layer 210B proximal to the second upper dielectric layer 220B has a beak-like shape with a gradually reduced thickness, and an end portion of the second upper dielectric layer 220B proximal to the second lower dielectric layer 210B is smoothly joined to the beak-like portion of the second lower dielectric layer 210B.

It is to be noted that the smooth joining of the beak-like portion of the second lower dielectric layer 210B to the second upper dielectric layer 220B can significantly mitigate the problem of an excessively small thickness of the second upper dielectric layer 220 at the end where it is joined to the second lower dielectric layer 210B and avoid the presence of any sharp corner there, which may concentrate an electric field and thus cause current leakage.

In this embodiment, an end portion of the first lower dielectric layer 210A of the first dielectric layer 200A proximal to the first upper dielectric layer 220A is also a beak-like portion with a gradually reduced thickness, and this beak-like portion of the first lower dielectric layer 210A is situated at the same or almost the same height as the beak-like portion of the second lower dielectric layer 210B. Specifically, first and second lower dielectric layers 210A, 210B may be formed in the same process step so that the beak-like portions of the first and second lower dielectric layers 210A, 210B are formed simultaneously and located at the same or almost the same height.

Further, the second gate electrode 300B resides on the second dielectric layer 200B and fills a bottom portion of the second trench 110B so that its top surface is above the shield electrode 310A. Specifically, the top surface of the second gate electrode 300B is higher than the bottom of the first gate electrode 320A so that there is a lateral overlap between the second gate electrode 300B and the first gate electrode 320A, which is necessary for the formation of the SBR. For example, the top surface of the second gate electrode 300B may be flush or nearly flush with the first gate electrode 320A.

Therefore, in this embodiment, a source region 420 and a well region 410 may also be formed beside the second trench 110B in the source-connecting region 100B, which form the SBR together with the second gate electrode 300B. Moreover, the second gate electrode 300B is an integral structure filling up a bottom portion of the trench, with its top surface reaching a desired height. This integral structure can be fabricated more easily, when compared to the conventional structure with the upper and lower portions being separated from each other.

Further, the second upper dielectric layer 220B is relatively thin, thus allowing the SBR to be turned on at a low voltage (e.g., lower than 0.7 V, 0.55 V or the like) to effectuate current rectification for fast turn-off of the device. In this embodiment, the second upper dielectric layer 220B of the second dielectric layer 200B (including the portions of the second dielectric layer 200B vertically corresponding to the first gate electrode) is thinner than the first upper dielectric layer 220A of the first dielectric layer 200A (including the portions of the first dielectric layer 200A vertically corresponding to the first gate electrode). This allows the SBR incorporating the second upper dielectric layer 220B to be turned on to provide current rectification at a voltage that is not high enough to turn on the shielded gate trench FET incorporating the first upper dielectric layer 220A.

Specifically, the thickness of the second upper dielectric layer 220B may be, for example, between 40 Å and 100 Å. It is to be noted that the thickness of the second upper dielectric layer 220B may also be adjusted according to the concentration of dopant ions in the well region 410. For example, in order to maintain a low threshold voltage of the SBR, the thickness of the second upper dielectric layer 220B may be further reduced when the concentration of dopant ions in the well region 410 is relatively high, or the concentration of dopant ions in the well region 410 may be lowered when the thickness of the second upper dielectric layer 220B is relatively large.

With continued reference to Fig. 3, the source and well regions 420, 410 are formed not only in each cell region 100A to provide components of the shielded gate trench FET therein but also in the source-connecting region 100B to provide components of the SBR.

Specifically, the source and well regions 420, 410 in the cell region 100A are formed in the substrate 100 beside the first trench 110A so that they have lateral overlaps with the gate electrode 320A. As such, when the shielded gate trench FET is turned on, a conductive channel will emerge in the well region 410, which allows an electrical current to flow from the source region to a corresponding drain region.

Additionally, the source and well regions 420, 410 in the source-connecting region 100B (more precisely, the function-integrated region in the source-connecting region 100B) are formed in the substrate 100 beside the second trench 110B so that they have lateral overlaps with the second gate electrode 300B. Due to a low threshold voltage, the SBR in the source-connecting region 100B will be turned on at a voltage that is not high enough to turn on the shielded gate trench FETs connected in parallel with the SBR, speeding up drainage of charge carriers from the well region 410 and achieve rapid recovery of the semiconductor device.

In summary, according to this embodiment, the source-connecting region 100B can not only function to electrically pick up the shield electrodes in the transistors but also to integrate therein the SBR. As a result, the SBR is formed without occupying any additional space, resulting in a significant increase in space utilization of the shielded gate trench FETs.

### Embodiment 2

Differing from the first embodiment, a non-cell region according to a second embodiment includes a rectifier region and a source-connecting region, which are located in different locations and intended for distinct functions. Additionally, a SBR is formed in the rectifier region and a source-connecting structure in the source-connecting region.

Fig. 4 shows the layout of a semiconductor device according to the second embodiment of the present invention. As shown in Fig. 4, the non-cell region includes the rectifier region 100C and the source-connecting region 100B.

The SBR is formed in the rectifier region 100C. Specifically, a second trench of the SBR is formed in a substrate in the rectifier region 100C, and a second dielectric layer and a second gate electrode are formed in the second trench in the rectifier region 100C.

The second dielectric layer and the second gate electrode may be structured in a similar way as those in the first embodiment. That is, the second dielectric layer also includes a second lower dielectric layer and a second upper dielectric layer, which are joined to each other in the vertical direction, and the second upper dielectric layer has a thickness that is smaller than a thickness of the second lower dielectric layer. Additionally, an end portion of the second lower dielectric layer proximal to the second upper dielectric layer is a beak-like portion with a gradually reduced thickness, and the second upper dielectric layer is smoothly joined to the beak-like portion of the second lower dielectric layer. Further, the second gate electrode also fills up a bottom portion of the second trench, with its top surface being above that of a shield electrode. For example, the top surface of the second gate electrode may be flush with that of a first gate electrode. In this way, the so-formed second gate electrode is an integral structure.

Further, the source-connecting structure formed in the source-connecting region 100B includes: a third trench (not shown) formed in the substrate in the source-connecting region 100B; a third dielectric layer (not shown) covering both a bottom and a sidewall of the third trench; and a connecting electrode (not shown) filling the third trench, the connecting electrode connecting, and thus electrically picking up, the shield electrode.

In an optional implementation, the shield electrode in the cell region 100A, the second gate electrode in the rectifier region 100C and the connecting electrode in the source-connecting region 100B may be electrically connected to one another.

The semiconductor device may include a plurality of cell regions 100A, each having a first trench extending in a predetermined direction, and at least one rectifier region 100C, each having a second trench interposed between adjacent two of the first trenches. The first trenches all extend to, and communicate at one end, with the third trench. In this embodiment, the second trench in the rectifier region 100C may also extend in the predetermined direction to, and communicate at one end, with the third trench.

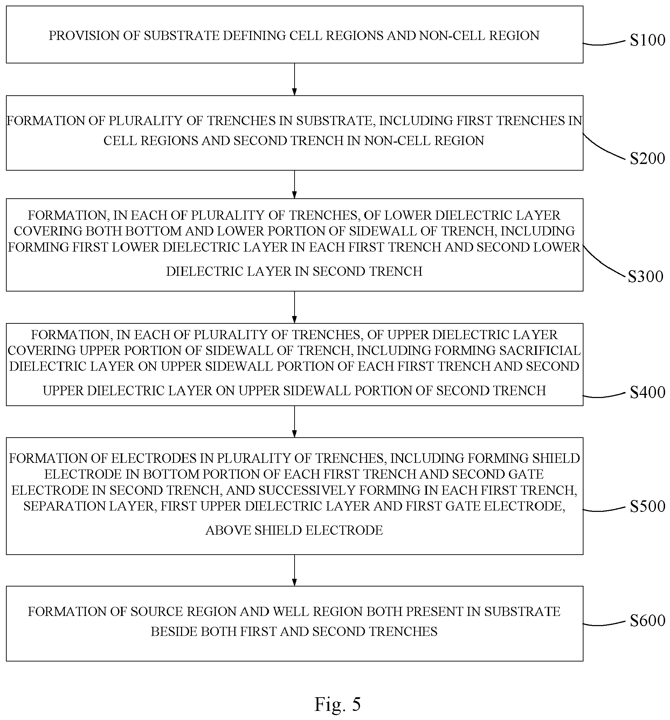

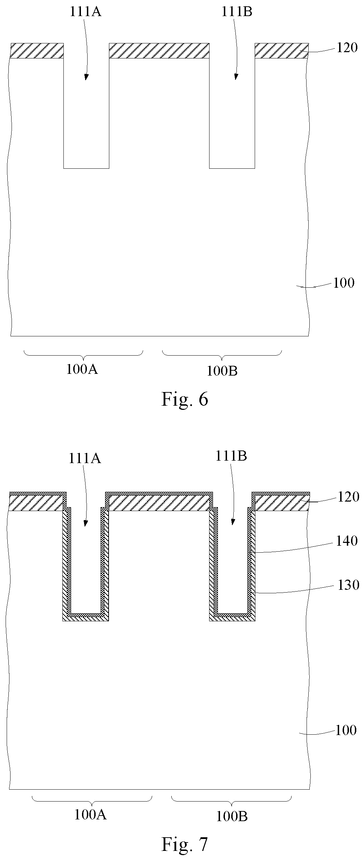

A method for forming a semiconductor device as defined above will be described in detail below with reference to Fig. 5 and Figs. 6 to 15. Fig. 5 is a flowchart of this method, and Figs. 6 to 15 schematically illustrate intermediate structures during the method.

In step S100, with particular reference to Fig. 6, a substrate 100 defining cell regions 100A and a non-cell region is provided.

Shielded gate trench FETs are to be formed in the respective cell regions 100A. As described above in connection with the second embodiment, the non-cell region may include a rectifier region and a source-connecting region, which are located in different locations. A SBR is to be formed in the rectifier region, and a source-connecting structure for electrically connecting shield electrodes in the transistors is to be formed in the source-connecting region. Alternatively, as described above in connection with the first embodiment, the non-cell region may include only a source-connecting region in which both the source-connecting structure and the SBR are to be formed.

The following description is given in the context of the non-cell region including a source-connecting region 100B in which both the source-connecting structure and the SBR are to be formed, as an example.

In step S200, with continued reference to Figs. 6 to 9, a plurality of trenches is formed in the substrate 100, which includes first trenches 110A in the cell regions 100A and a second trench 110B in the non-cell region (i.e., the source-connecting region 100B according to this embodiment). In this embodiment, the first trenches 110A communicate with the second trench 110B.

Subsequently, in each of the first trenches 110A, a first dielectric layer, a shield electrode and a first gate electrode are formed, thus forming a shielded gate trench FET. In addition, a second dielectric layer and a second gate electrode are formed in the second trench 110B, thus forming the SBR and the source-connecting structure.

As described in the Background section, during the formation of a very thin upper dielectric layer of a second dielectric layer by performing an oxidation process in a rectifier region, insufficient oxidation tends to occur at corners, leading to a thickness of the resulting oxide layer there that is too small to prevent current leakage.

In view of this, in this embodiment, a local oxidation process can be employed to form a lower dielectric layer having a beak-like portion, which ensures sufficient oxidation of a trench sidewall portion close to the lower dielectric layer during the subsequent formation of an upper dielectric layer and hence a sufficient thickness of the resulting upper dielectric layer at the portion thereof where it is joined to the lower dielectric layer. In addition, it allows smoother joining of the upper dielectric layer at its bottom to the lower dielectric layer, resulting in increased resistance to current leakage.

In this embodiment, the trenches are formed using such a specific method that an upper sidewall portion of each trench is covered by a silicon oxide layer, which is in turn covered by a silicon nitride layer. With the silicon oxide layer and the silicon nitride layer serving as a mask, the local oxidation process is carried out to form the lower dielectric layer with the beak-like portion.

Specifically, the method for forming the first and second trenches 110A, 110B may include the following steps.

In a first step, with reference specifically to Fig. 6, a mask layer 120 is formed on a top surface of the substrate 100, and the substrate 100 is etched with the aid of the mask layer 120, so that first upper trenches 111A and a second upper trench 111B are formed in the substrate 100, with the bottoms of first upper trenches 111A and the second upper trench 111B located at a first depth.

After the substrate 100 has been etched, sacrificial oxide layers may be formed on inner surfaces of the first and second upper trenches 111A, 111B by performing an oxidation process and then removed, thereby repairing possible impairments in the inner surfaces of the first and second upper trenches 111A, 111B that may result from the etching process.

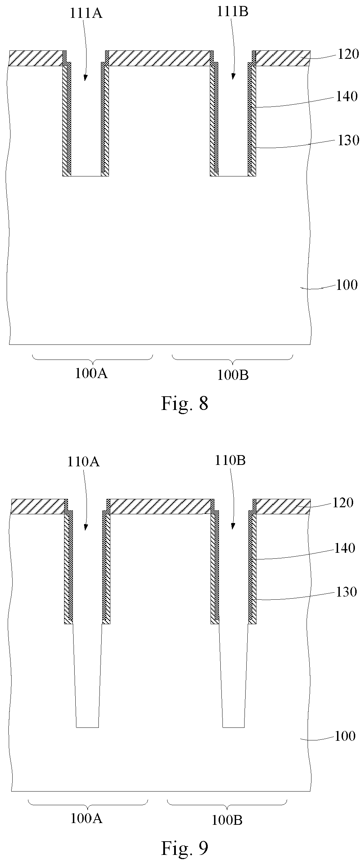

In a second step, with reference specifically to Figs. 7 and 8, silicon oxide layers 130 and respective silicon nitride layers 140 are successively formed on respective sidewalls of the first and second upper trenches 111A, 111B, with bottoms of the first and second upper trenches 111A, 111B being exposed.

The formation of the silicon oxide layers 130 and the silicon nitride layers 140 may include successively forming material layers of silicon oxide and silicon nitride and etching away portions of these material layers over the trench bottoms, so that the bottoms of the first and second upper trenches 111A, 111B are exposed.

In a third step, with reference specifically to Fig. 9, an etching process is performed at the bottoms of the first and second upper trenches 111A, 111B with the silicon nitride layers 140 serving as masks, thus lowering the bottoms to a second depth and resulting in the formation of the first and second trenches 110A, 110B.

It is to be noted that, in this embodiment, the full-depth first and second trenches 110A, 110B are formed using at least two etching steps. Compared with the conventional practice of directly forming such trenches in a single etching step, the multi-etch approach according to this embodiment allows easier control of etching accuracy and improved pattern precision. Moreover, subsequent to the formation of the first and second trenches 110A, 110B with the aid of the silicon oxide layers 130 and the silicon nitride layers 140, these layers are still retained so that a local oxidation process can be performed subsequently based on them in order to form lower dielectric layers with beak-like portions, as described below in step S300.

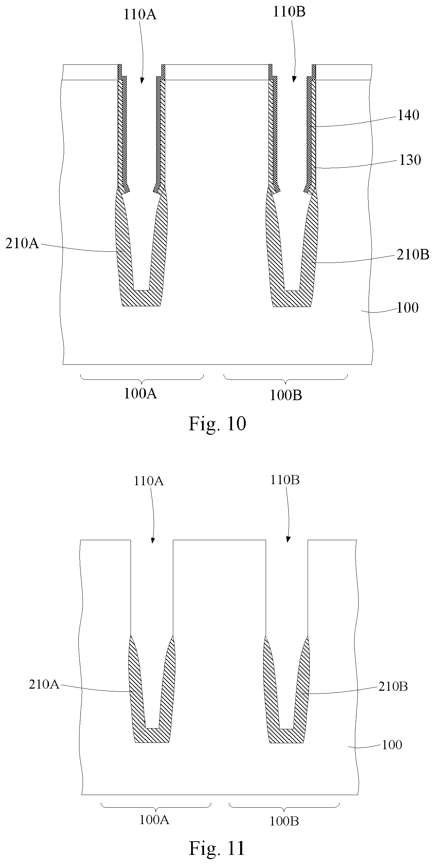

In step S300, with reference specifically to Fig. 10, lower dielectric layers are formed on both the respective bottom and respective lower sidewall portions of the plurality of trenches. This step includes forming first lower dielectric layers 210A in the respective first trenches 110A and a second lower dielectric layer 210B in the second trench 110B so that at least the second lower dielectric layer 210B has a tapered beak-like end portion.

In this embodiment, the first and second lower dielectric layers 210A, 210B may be formed simultaneously in a single process such as a single oxidation process so that they have equal or nearly equal thicknesses to jointly impart the device high voltage resistance.

Specifically, the formation of the first and second lower dielectric layers 210A, 210B may include, with the silicon oxide layers 130 and the silicon nitride layers 140 serving as masks, performing a local oxidation (LOCOS) process such that first and second lower dielectric layers 210A, 210B each with a beak-like portion are formed. Since such a LOCOS process tends to result in the formation of a relatively thick oxide layer, it can be effectively ensured that the resulting shielded gate trench FETs have sufficient voltage resistance.

Reference is now made to Fig. 11. Subsequent to the formation of the first and second lower dielectric layers 210A, 210B, the silicon oxide layers and the silicon nitride layers can be removed, thus exposing the upper sidewall portions of the first and second trenches 110A, 110B.

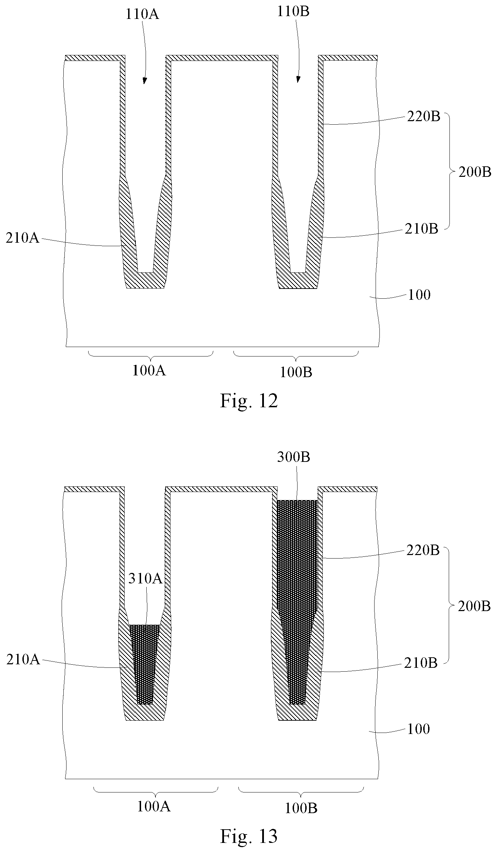

In step S400, with reference specifically to Fig. 12, upper dielectric layers are formed on the respective upper sidewall portions of the plurality of trenches. This step includes forming sacrificial dielectric layers on the respective upper sidewall portions of the first trenches 110A and forming a second upper dielectric layer 220B on the upper sidewall portion of the second trench 110B.

Specifically, the upper dielectric layers may be formed simultaneously in the first and second trenches 110A, 110B in absence of any mask, so that those in the first trenches 110A constitute the sacrificial dielectric layers that are to be removed subsequently, while the upper dielectric layer 220B in the second trench 110B is retained to serve as a gate oxide layer of the SBR.

With continued reference to Fig. 12, in this embodiment, the formation of the upper dielectric layers includes performing a first oxidation process so that the second upper dielectric layer 220B is formed over the upper sidewall portion of the second trench 110B. The second upper dielectric layer 220B has a relatively small thickness, for example, between 40 Å and 100 Å. In the first oxidation process, upper dielectric layers (i.e., the sacrificial dielectric layers) are also formed on the respective upper sidewall portions of the first trenches 110A. These sacrificial dielectric layers will be removed subsequently, followed by the formation of first upper dielectric layers with a desired thickness by virtue of another oxidation process, as detailed below.

It is to be noted that since the second lower dielectric layer 210B has a beak-like end portion tapered upward, sufficient contact between oxygen and the trench sidewall is allowed around this end. As a result, during the oxidation process, it can be ensured that the resulting oxide layer on the trench sidewall will not have an excessively small thickness near the end close to the second lower dielectric layer 210B and that the second upper dielectric layer 220B will be smoothly joined to the beak-like portion of the second lower dielectric layer 210B. This, on the one hand, mitigates the problem of an excessively small thickness of the second upper dielectric layer 220B at its portion where it is joined to the second lower dielectric layer 210B, and on the other hand, avoid any sharp corner present at the portion where the second upper dielectric layer 220B is joined to the second lower dielectric layer 210B, resulting in a significant reduction in electric field concentration and an additional suppression of the device's current leakage.

In step S500, with reference specifically to Figs. 13 to 14, electrodes are formed in the plurality of trenches, including shield electrodes 310A in respective lower portions of the first trenches 110A and a second gate electrode 300B in the second trench 110B. The second gate electrode 300B fills up a bottom portion of the second trench 110B, with its top surface being above those of the shield electrodes 310A. Further, in each of the first trenches 110A, a separation layer, a first upper dielectric layer 220A and a first gate electrode 320A are successively stacked over the shield electrode 310A.

In this embodiment, the second gate electrode 300B in the second trench 110B is electrically connected to the shield electrodes 310A. Specifically, the formation of the second gate electrode 300B and the shield electrodes 310A includes filling up the plurality of trenches with a conductive electrode material layer having a top flush with or slightly lower than those of the trenches so that the electrode material layer in the second trench 110B directly forms the second gate electrode 300B. Next, the electrode material layers in the respective first trenches 110A are each partially removed, resulting in the formation of the shield electrodes 310A in the respective lower portions of the first trenches 110A. Specifically, the electrode material layers in the respective first trenches 110A may be etched back and thinned, with the electrode material layer in the second trench 110B being protected with a mask, thus resulting in the formation of the shield electrodes 310A.

It is to be noted that during the etching process for partially removing the individual electrode material layers in the respective first trenches 110A, the sacrificial dielectric layers on the upper sidewall portions of the first trenches 110A will be exposed and impaired. For this reason, prior to the formation of the first gate electrodes, the sacrificial dielectric layers are generally removed, followed by the formation of the first upper dielectric layers using an oxidation process.

Conventionally, the electrode in the second trench 110B was split into an upper portion and a lower portion, thus requiring the removal of the upper dielectric layer in the second trench prior to the formation of the upper electrode portion, followed by shielding the first trenches 110A with photoresist via photolithography and then again forming the upper dielectric layer using another oxidation process. By contrast, according to this embodiment, since the second gate electrode 300B is an integral part with its top close to that of the second trench 110B, it can cover the majority of the second upper dielectric layer 220B, making it possible to directly retain the second upper dielectric layer 220B as a gate oxide layer of the SBR. Therefore, compared with the conventional method, this embodiment can save a photolithography process and avoid the problem of residual photoresist that tends to occur in association with filling of the first trenches with photoresist.

Further, for each of the first trenches 110A, the formation of the shield electrode may be followed by the formation of the separation layer that covers the shield electrode 310A and thus avoid it from forming a short circuit with the subsequently-formed first gate electrode 320A. In an optional implementation, the sacrificial dielectric layers on the upper sidewall portions of the first trenches 110A may be removed during the formation of the separation layers. Of course, in other implementations, the formation of the separation layers may follow the removal of the sacrificial dielectric layers.

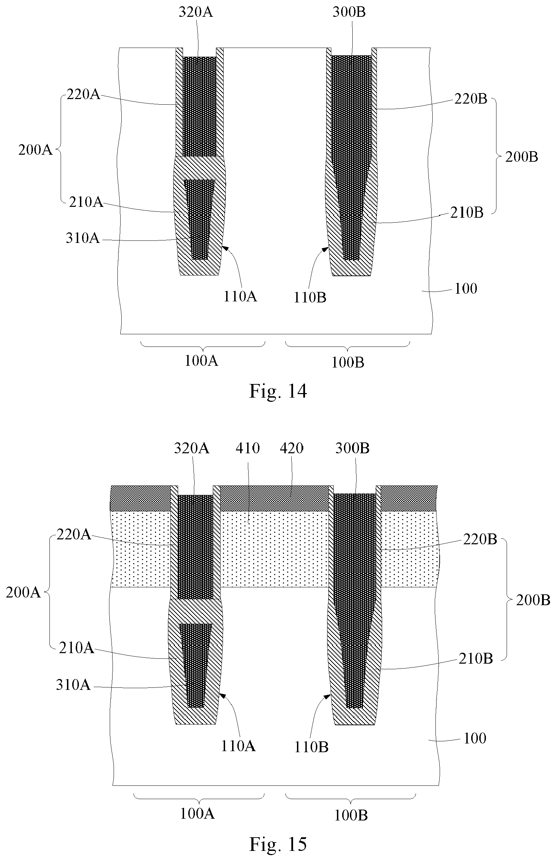

Next, referring to Fig. 14, in each of the first trenches 110A, the first upper dielectric layer 220A and the first gate electrode 320A are formed over the separation layer. The first upper dielectric layer 220A may be formed using a second oxidation process so that its thickness is greater than that of the second upper dielectric layer 220B.

In step S600, with reference specifically to Fig. 15, a well region 410 and a source region 420 are formed in the substrate beside the first trenches 110A, thus forming the shielded gate trench FETs in the respective cell regions 100A. The well region 410 and the source region 420 are also present in the substrate beside the second trench 110B, thus forming the SBR in the non-cell region (i.e., the source-connecting region 100B according to this embodiment).

Specifically, a bottom of the well region 410 is not lower than bottoms of the first gate electrodes 320A, and a bottom of the source region 420 is not higher than tops of the first gate electrode 320A such that each of the source and well regions 420, 410 has a lateral overlap with each of the first gate electrodes 320A, allowing the formation of the shielded gate trench FETs in the respective cell regions 100A. Likewise, in the source-connecting region 100B, each of the source and well regions 420, 410 has a lateral overlap with the second gate electrode 300B, allowing the formation of the SBR.

In summary, in semiconductor devices according to embodiments of the present invention, the second dielectric layer that serves as a component of the SBR has an upper dielectric layer and a lower dielectric layer with a beak-like portion that is smoothly joined to the upper dielectric layer. This can not only avoid the formation of a sharp corner between the upper and lower dielectric layers where electric field concentration may occur, but can also effectively mitigate the problem of an excessively small thickness around the bottom of the upper dielectric layer, which may lead to current leakage of the device.

Specifically, at least during the formation of the SBR's second dielectric layer, a local oxidation process is performed to form a second lower dielectric layer with such a beak-like portion. In this case, when another oxidation process is subsequently carried out to form a thin second upper dielectric layer, sufficient contact between oxygen and the trench sidewall close to the second lower dielectric layer can be ensured, thus avoiding an excessively small thickness of the resulting second upper dielectric layer at the bottom thereof and enabling it to be smoothly joined to the second lower dielectric layer.

Further, since the second gate electrode in the SBR is an integral unitary part, it can be formed more easily, when compared with the conventional structure split into an upper portion and a lower portion. Specifically, during the formation of the integral second gate electrode, it is no longer necessary to perform an etch-back process on the electrode material in the second trench, which may bring damage to the upper dielectric layer in the second trench, or to shield the first trenches in the respective cell regions through photolithography. As a result, both the number of necessary process steps and cost can be reduced, and the problem of residual photoresist in the first trenches can be avoided.

Furthermore, the SBR may be integrated in the source-connecting region (in this case, the well region and source region also spread to the substrate in the source-connecting region). That is, the source-connecting region is used not only to electrically pick up the shield electrodes in the shielded gate trench FETs but also to integrate the SBR for enabling fast turn-off of the transistor devices. Therefore, integrating the SBR in the source-connecting region can not only increase the device's reverse recovery but can also release the space occupied by the rectifier region and hence increase space utilization of the cell regions.

It is to be noted that, while the invention has been described with reference to several preferred embodiments, it is not intended to be limited to these embodiments in any way. In light of the teachings hereinabove, any person of skill in the art may make various possible variations and changes to the disclosed embodiments or modify them into equivalent alternatives, without departing from the scope of the invention. Accordingly, any and all such simple variations, equivalent alternatives and modifications made to the foregoing embodiments without departing from the scope of the invention are intended to fall within the scope thereof.

It is also to be understood that the terminology used herein is used for the purpose of describing particular embodiments only, and is not intended to limit the scope of the present invention. It must be noted that as used herein and in the appended claims, the singular forms "a" and "an" include the plural reference unless the context clearly dictates otherwise. Thus, for example, a reference to "a step" or "a means" is a reference to one or more steps or means and may include sub-steps and subservient means. All conjunctions used are to be understood in the most inclusive sense possible. Thus, the word "or" should be understood as having the definition of a logical "or" rather than that of a logical "exclusive or" unless the context clearly necessitates otherwise. Implementation of the methods and/or device according to the embodiments of the present invention involves performing or completing certain selected tasks or steps manually, automatically, or a combination thereof.

## Claims

1. A semiconductor device, comprising:
a substrate (100) defining a cell region (100A) and a non-cell region, the non-cell region comprising a source-connecting region (100B);
a shielded gate trench field effect transistor (FET) formed in the cell region (100A), the shielded gate trench FET comprising: a first trench (110A) formed in the substrate (100); a first dielectric layer (200A) covering both a bottom and a sidewall of the first trench (110A); and a shield electrode (310A), a separation layer and a first gate electrode (320A), which are sequentially stacked in the first trench (110A); and
a super barrier rectifier (SBR) formed in the non-cell region, the SBR comprising: a second trench (110B) formed in the substrate (100); a second dielectric layer (200B) covering both a bottom and a sidewall of the second trench (110B), the second dielectric layer (200B) comprising a second lower dielectric layer (210B) and a second upper dielectric layer (220B) residing on and joined to the second lower dielectric layer (210B), the second upper dielectric layer (220B) having a thickness smaller than a thickness of the second lower dielectric layer (210B), the second lower dielectric layer (210B) having a beak-like portion proximal to and tapered in thickness toward the second upper dielectric layer (220B), the second upper dielectric layer (220B) smoothly joined to the beak-like portion of the second lower dielectric layer (210B), the thickness of the second upper dielectric layer (220B) further being smaller than a portion of the first dielectric layer (200A) that vertically corresponds to the first gate electrode; and a second gate electrode (300B) filling up a bottom portion of the second trench (110B), with a top surface of the second gate electrode (300B) being above the shield electrode (310A), both the second gate electrode (300B) and the shield electrode (310A) being electrically picked up by the source-connecting region (100B).

2. The semiconductor device of claim 1, wherein the non-cell region further comprises a rectifier region (10C),
wherein the SBR is formed in the rectifier region (10C), and
wherein a source-connecting structure is formed in the source-connecting region (100B), the source-connecting structure comprising: a third trench formed in the substrate (100); a third dielectric layer covering both a bottom and a sidewall of the third trench; and a connecting electrode filling up the third trench, the connecting electrode connecting to the shield electrode (310A) for electrically picking up the shield electrode (310A).

3. The semiconductor device of claim 2, wherein the substrate (100) defines a plurality of cell regions (100A) and at least one rectifier region (10C), wherein the first trenches (110A) of the plurality of cell regions (100A) all extend in a predetermined direction, the second trench (110B) in each of the at least one rectifier region (10C) interposed between adjacent first trenches (110A), and wherein the first trenches (110A) all extend to the third trench at ends thereof to communicate with the third trench.

4. The semiconductor device of claim 1, wherein a source-connecting structure is formed in the source-connecting region (100B), the source-connecting structure comprising:
a third trench formed in the substrate (100), wherein at least part of the third trench constitutes the second trench (110B) of the SBR and is defined as a function-integrated region;
a third dielectric layer covering both a bottom and a sidewall of the third trench, wherein a portion of the third dielectric layer formed within the function-integrated region constitutes the second dielectric layer (200B) of the SBR; and
a connecting electrode filling up the third trench, the connecting electrode electrically connecting the shield electrode (310A), wherein a portion of the connecting electrode formed within the function-integrated region constitutes the second gate electrode (300B) of the SBR.

5. The semiconductor device of claim 4, wherein the substrate (100) defines a plurality of cell regions (100A), wherein the first trenches (110A) of the plurality of cell regions (100A) all extend in a predetermined direction, and wherein the first trenches (110A) all extend to the second trench (110B) at ends thereof to communicate with the second trench (110B).

6. The semiconductor device of claim 1, wherein the thickness of the second upper dielectric layer (220B) is between 40 Å and 100 Å.

7. The semiconductor device of claim 1, wherein the first dielectric layer (200A) comprises a first lower dielectric layer (210A) and a first upper dielectric layer (220A) residing on and joined to the first lower dielectric layer (210A), the first lower dielectric layer (210A) covering both the bottom of the first trench (110A) and a portion of the sidewall of the first trench (110A) that corresponds to the shield electrode (310A), the first upper dielectric layer (220A) covering at least a portion of the sidewall of the first trench (110A) that corresponds to the first gate electrode (320A), wherein the first lower dielectric layer (210A) has a beak-like portion proximal to and tapered in thickness toward the first upper dielectric layer (220A), and wherein the beak-like portion of the first lower dielectric layer (210A) is located at a height that is equal to a height where the beak-like portion of the second lower dielectric layer (210B) is located.

8. The semiconductor device of claim 1, wherein the first trench (110A) and the second trench (110B) are equal in depth.

9. The semiconductor device of claim 1, further comprising a source region (420) and a well region (410) formed in the substrate (100) beside the first trench (110A) and each having a lateral overlap with the first gate electrode (320A), the source region (420) and the well region (410) further extending to the substrate (100) beside the second trench (110B) and each having a lateral overlap with the second gate electrode (300B).

10. A method of forming a semiconductor device, comprising:
providing a substrate (100) defining a cell region (100A) and a non-cell region;
forming a plurality of trenches in the substrate (100), the plurality of trenches including a first trench (110A) in the cell region (100A) and a second trench (110B) in the non-cell region;
forming a lower dielectric layer covering both a bottom and a lower portion of a sidewall of each of the plurality of trenches, wherein forming the lower dielectric layer comprises forming a first lower dielectric layer (210A) in the first trench (110A) and a second lower dielectric layer (210B) in the second trench (110B) so that at least an end portion of the second lower dielectric layer (210B) is a beak-like portion with a gradually reduced thickness;
forming an upper dielectric layer covering an upper portion of the sidewall of each of the plurality of trenches, wherein forming the upper dielectric layer comprises forming a sacrificial dielectric layer on the upper portion of the sidewall of the first trench (110A) and a second upper dielectric layer (220B) on the upper portion of the sidewall of the second trench (110B), the second upper dielectric layer (220B) having a thickness smaller than a thickness of the second lower dielectric layer (210B), the second upper dielectric layer (220B) smoothly joined to the beak-like portion of the second lower dielectric layer (210B); and
forming electrodes in the plurality of trenches, wherein forming the electrodes comprises: forming a shield electrode (310A) in a bottom portion of the first trench (110A) and a second gate electrode (300B) in the second trench (110B), the second gate electrode (300B) filling up a bottom portion of the second trench (110B) and having a top surface above the shield electrode (310A); and successively forming, above the shield electrode (310A), a separation layer, a first upper dielectric layer (220A) and a first gate electrode (320A) in the first trench (110A), the first upper dielectric layer (220A) having a thickness greater than a thickness of the second upper dielectric layer (220B).

11. The method of claim 10, wherein forming the plurality of trenches in the substrate (100) comprises:
forming a mask layer (120) on a top surface of the substrate (100) and etching the substrate (100) using the mask layer (120), so that a first upper trench (111A) is formed in the substrate (100) in the cell region (100A) and a second upper trench (111B) is formed in the substrate (100) in the non-cell region;
successively forming a silicon oxide layer (130) and a silicon nitride layer (140) over a sidewall of each of the first and second upper trenches (111A, 111B), with a bottom of each of the first and second upper trenches being exposed; and
etching the bottoms of the first and second upper trenches with the silicon nitride layers (140) serving as masks so that the bottoms of the first and second upper trenches extend downward to form the first and the second trenches.

12. The method of claim 11, wherein forming the lower dielectric layer covering both the bottom and the lower portion of the sidewall of each of the plurality of trenches comprises:
performing a local oxidation process with the silicon oxide layer (130) and the silicon nitride layer (140) together serving as a mask, thereby forming the first lower dielectric layer (210A) having a beak-like portion in the first trench (110A) and the second lower dielectric layer (210B) having a beak-like portion in the second trench (110B).

13. The method of claim 12, wherein forming the upper dielectric layer covering the upper portion of the sidewall of each of the plurality of trenches comprises:
removing the silicon oxide layer (130) and the silicon nitride layer (140), exposing the upper portion of the sidewall of each of the first and second trenches above the lower dielectric layer; and
performing a first oxidation process, thereby forming the sacrificial dielectric layer on the upper portion of the sidewall of the first trench (110A) and the second upper dielectric layer (220B) on the upper portion of the sidewall of the second trench (110B).

14. The method of claim 13, wherein forming the electrodes in the plurality of trenches comprises:
filling each of the plurality of trenches with an electrode material layer, wherein a portion of the electrode material layer in the second trench (110B) forms the second gate electrode (300B) that covers the second upper dielectric layer (220B);
removing a portion of the electrode material layer in the first trench (110A) so that a remaining portion of the electrode material layer on the bottom of the first trench (110A) forms the shield electrode (310A) and the sacrificial dielectric layer in the first trench (110A) is exposed;
forming the separation layer in the first trench (110A) to cover the shield electrode (310A) and removing the sacrificial dielectric layer, thereby exposing the upper portion of the sidewall of the first trench (110A); and
forming the first upper dielectric layer (220A) in the first trench (110A) by performing a second oxidation process and forming the first gate electrode (320A) in the first trench (110A).

15. The method of claim 10, further comprising forming a source region (420) and a well region (410), the source region and the well region (410) both formed in the substrate (100) beside the first trench (110A) and thereby forming a shielded gate trench field effect transistor (FET) in the cell region (100A), the well region (410) and the source region (420) also both formed in the substrate (100) beside the second trench (110B) and thereby forming a super barrier rectifier (SBR) in the non-cell region.
